# EUROPÄISCHE PATENTSCHRIFT

(11) **EP 3 360 167 B1**
(45) Veröffentlichungstag und Bekanntmachung des Hinweises auf die Patenterteilung: **29.11.2023**
(21) Anmeldenummer: 16775745.9
(22) Anmeldetag: 05.10.2016
(51) Int. Cl.: H01L 33/48, H01L 33/62, H01L 25/075

(54) **OPTOELEKTRONISCHES BAUELEMENT MIT EINEM LEITERRAHMEN MIT EINER VERSTEIFUNGSSTRUKTUR**
OPTOELECTRONIC COMPONENT HAVING A LEAD FRAME HAVING A STIFFENING STRUCTURE
ÉLÉMENT OPTOÉLECTRONIQUE DOTÉ D'UN CHÂSSIS DE CONNEXION POURVU D'UNE STRUCTURE DE RENFORCEMENT

(30) Priorität: 05.10.2015 DE 102015116855
(43) Veröffentlichungstag der Anmeldung: 15.08.2018
(73) Patentinhaber: OSRAM Opto Semiconductors GmbH, 93055 Regensburg (DE)
(72) Erfinder: RICHTER, Daniel, 93077 Bad Abbach (DE)
(74) Vertreter: Patentanwaltskanzlei WILHELM & BECK
(86) Internationale Anmeldenummer: PCT/EP2016/073752
(87) Internationale Veröffentlichungsnummer: WO 2017/060280

(56) Entgegenhaltungen:
- DE-A1-102014 102 184
- JP-A- 2015 037 101
- US-A1- 2012 138 967
- US-A1- 2013 221 509

## Beschreibung

Die Erfindung betrifft ein optoelektronisches Bauelement mit wenigstens einem optoelektronischen Halbleiterchip und einem Leiterrahmen mit einer Versteifungsstruktur und ein Verfahren zur Herstellung des optoelektronischen Bauelementes.

Diese Patentanmeldung beansprucht die Priorität der deutschen Patentanmeldung 10 2015 116 855. 3.

Aus dem Stand der Technik sind optoelektronische Bauelemente mit unterschiedlichen Gehäusen bekannt. Die Gehäuse sind dabei für spezielle Anwendungszwecke optimiert. Geänderte Anforderungen erfordern in der Regel eine Neuentwicklung des Gehäuses eines optoelektronischen Bauelementes.

Aus DE 10 2014 102 184 A1 ist ein Verfahren zum Herstellen eines optoelektronischen Bauelements bekannt, bei dem ein strahlungsemittierendes Bauteil auf einen Leiterrahmenabschnitt aufgebracht wird. Zudem ist ein zweiter Leiterrahmenabschnitt vorgesehen.

Die zwei Leiterrahmenabschnitte weisen Aussparungen auf. Die zwei Leiterrahmenabschnitte werden mit dem strahlungsemittierenden Bauteil in einen Formkörper eingebettet.

Aus US 2013/221509 A1 ist ein optoelektronisches Bauelement mit wenigstens einem optoelektronischen Halbleiterchip bekannt, wobei der Halbleiterchip auf einem Leiterrahmenabschnitt angeordnet ist, wobei das Bauelement weiterhin eine seitlich vom Leiterrahmenabschnitt wegragende Versteifungsstruktur aufweist, und wobei der Leiterrahmenabschnitt, die Versteifungsstruktur und der Halbleiterchip in einem elektrisch isolierenden Gehäuse eingebettet sind.

Eine Aufgabe der vorliegenden Erfindung besteht darin, ein verbessertes optoelektronisches Bauelement und ein verbessertes Verfahren zum Herstellen eines optoelektronischen Bauelementes bereitzustellen.

Diese Aufgabe wird durch das optoelektronische Bauelement mit den Merkmalen des Anspruchs 1 und mit dem Verfahren zum Herstellen des optoelektronischen Bauelementes mit den Merkmalen des Anspruchs 8 gelöst.

Das vorgeschlagene optoelektronische Bauelement umfasst einen Leiterrahmenabschnitt, auf dem wenigstens ein optoelektronischer Halbleiterchip aufgebracht ist. Das Bauelement weist weiterhin eine Versteifungsstruktur auf. Der Leiterrahmenabschnitt, die Versteifungsstruktur und der Halbleiterchip sind in einem elektrisch isolierenden Gehäuse eingebettet. Durch das Vorsehen der Versteifungsstruktur wird eine stabile Verankerung des Leiterrahmenabschnittes in dem Gehäuse erreicht.

Die Versteifungsstruktur ist mit einem weiteren Leiterrahmenabschnitt verbunden. Auf dem weiteren Leiterrahmenabschnitt ist auf einer Oberseite des weiteren Leiterrahmenabschnittes ein Leitungselement angeordnet. Der weitere Leiterrahmenabschnitt und abhängig von der gewählten Ausführungsform das Leitungselement sind in dem Gehäuse ebenfalls eingebettet. Durch das Vorsehen des weiteren Leiterrahmenabschnittes wird eine bessere mechanische Fixierung des Halbleiterchips im Gehäuse erreicht. Zudem besteht eine erhöhte Flexibilität für eine elektrische Kontaktierung des Halbleiterchips über den weiteren Leiterrahmenabschnitt.

Dazu kann ein elektrisch leitendes Leitungselement auf dem weiteren Leiterrahmenabschnitt angeordnet sein. Abhängig von der gewählten Ausführungsform grenzt der Halbleiterchip bis an die Oberseite des Gehäuses. Somit kann auf einfache Weise eine elektrische Kontaktierung des Halbleiterchips auf der Oberseite des Gehäuses erreicht werden. Zudem grenzt das Leitungselement ebenfalls bis an die Oberseite des Gehäuses. Somit kann auch das Leitungselement auf einfache Weise über die Oberseite des Gehäuses elektrisch kontaktiert werden.

In einer Ausführungsform ist auf einer Oberseite des Gehäuses eine elektrische Leitung aufgebracht, wobei die elektrische Leitung mit wenigstens einem Halbleiterchip elektrisch kontaktiert ist. Auf diese Weise wird eine einfache und sichere elektrische Kontaktierung eines Anschlusses des Halbleiterchips erreicht.

In einer Ausführungsform weist das Bauelement eine weitere Versteifungsstruktur auf, die mit wenigstens einem weiteren, weiteren Leiterrahmenabschnitt verbunden ist. Auf dem weiteren, weiteren Leiterrahmenabschnitt kann ein weiteres Leitungselement vorgesehen sein, das auf einer Oberseite des weiteren, weiteren Leiterrahmenabschnittes angeordnet ist. Die weitere Versteifungsstruktur ist mit dem weiteren, weiteren Leiterrahmenabschnitt und dem weiteren Leitungselement in das Gehäuse eingebettet. Auf diese Weise wird eine erhöhte Flexibilität bei der elektrischen Kontaktierung und bei der elektrischen Stromführung im Gehäuse ermöglicht.

Abhängig von der gewählten Ausführungsform können die Versteifungsstruktur und die weitere Versteifungsstruktur und der weitere und der weitere, weitere Leiterrahmenabschnitt auf gegenüberliegenden Seiten des Leiterrahmenabschnittes angeordnet sein.

In einer weiteren Ausführungsform ist auf einer Oberseite des Gehäuses eine elektrische Leitung aufgebracht, wobei die elektrische Leitung mit einer Oberseite des wenigstens einen Halbleiterchips elektrisch kontaktiert ist. Auf diese Weise wird eine einfache und sichere elektrische Kontaktierung eines Anschlusses des Halbleiterchips erreicht.

In einer weiteren Ausführungsform ist die elektrische Leitung mit wenigstens einer Oberseite eines Leitungselementes elektrisch kontaktiert. Auf diese Weise kann eine einfache elektrische Kontaktierung eines zweiten Anschlusses des Halbleiterchips über das Leitungselement und über den Leiterrahmenabschnitt beziehungsweise den weiteren Leiterrahmenabschnitt erreicht werden.

In einer weiteren Ausführungsform ist ein zweiter Halbleiterchip auf dem Leiterrahmenabschnitt angeordnet. Der zweite Halbleiterchip kann in der gleichen Art und Weise wie der erste Halbleiterchip mit einer elektrischen Leitung beziehungsweise mit einem Leitungselement elektrisch leitend verbunden sein. Je nach Ausführungsform können auch mehr als zwei Halbleiterchips auf einem Leiterrahmenabschnitt angeordnet sein.

In einer Ausführungsform ist die Geometrie der Versteifungsstruktur wenigstens in einer Dimension kleiner gewählt als die Geometrie des Leiterrahmenabschnittes. Beispielsweise kann die Versteifungsstruktur eine kleinere Dicke und/oder eine kleinere Breite als der Leiterrahmenabschnitt aufweisen. Abhängig von der gewählten Ausführungsform sind die Versteifungsstruktur und der Leiterrahmenabschnitt einteilig ausgebildet. In analoger Weise kann auch die weitere Versteifungsstruktur eine kleinere Dicke und/oder eine kleinere Breite als der Leiterrahmenabschnitt aufweisen.

In einer weiteren Ausführungsform ist ein weiteres Gehäuse vorgesehen, das eine elektrische Leitungsstruktur aufweist.

Das weitere Gehäuse ist mit dem Gehäuse verbunden, wobei die Leitungsstruktur des weiteren Gehäuses mit wenigstens einem Halbleiterchip des Gehäuses elektrisch leitend verbunden ist.

Die Verwendung des weiteren Gehäuses bietet eine erhöhte Flexibilität bei der Ausbildung und der Führung der elektrischen Leitungen zur Kontaktierung des Bauelementes. Die Verwendung des weiteren Gehäuses ist insbesondere bei einem Bauelement mit mehreren Leitungsabschnitten und/oder mit mehreren Halbleiterchips von Vorteil.

Ein einfaches und kostengünstiges Verfahren zum Herstellen eines optoelektronischen Bauelements mit wenigstens einem optoelektronischen Halbleiterchip wird dadurch erreicht, dass ein Leiterrahmen mit mehreren über Versteifungsstrukturen miteinander verbundenen Leiterrahmenabschnitten vorgesehen ist. Auf wenigstens einen Leiterrahmenabschnitt wird wenigstens ein Halbleiterchip aufgebracht. Anschließend wird der Leiterrahmen mit dem Halbleiterchip in ein elektrisch isolierendes Gehäuse eingebettet. Dann wird der Leiterrahmenabschnitt mit dem Halbleiterchip und wenigstens einer Versteifungsstruktur von dem übrigen Leiterrahmen abgetrennt und somit das optoelektronische Bauelement erhalten. Der Leiterrahmenabschnitt ist über eine Versteifungsstruktur mit einem weiteren Leiterrahmenabschnitt verbunden. Vor dem Einbetten in das Gehäuse wird ein Leitungselement auf eine Oberseite des weiteren Leiterrahmenabschnittes aufgebracht. Nach dem Einbetten in das Gehäuse wird der Leiterrahmenabschnitt mit dem Halbleiterchip, die wenigstens eine Versteifungsstruktur und der weitere Leiterrahmenabschnitt mit dem Leitungselement von dem übrigen Leiterrahmen abgetrennt und das Bauelement erhalten.

In einer Ausführungsform ist der Leiterrahmenabschnitt, auf den der Halbleiterchip angeordnet ist über eine Versteifungsstruktur mit einem weiteren Leiterrahmenabschnitt verbunden. Der weitere Leiterrahmenabschnitt erhöht die mechanische Fixierung des Halbleiterchips im Gehäuse. Zudem kann der weitere Leiterrahmenabschnitt für eine effiziente elektrische Leitungsführung verwendet werden. Dazu kann der weitere Leiterrahmenabschnitt mit einem Leitungselement versehen werden, das bis zu einer Oberseite des Gehäuses geführt ist. Somit kann über das Leitungselement und die Oberseite des Gehäuses eine elektrische Kontaktierung einer Rückseite des Halbleiterchips erreicht werden.

In einer weiteren Ausführungsform werden der weitere Leiterrahmenabschnitt und das Leitungselement beim Abtrennen des Bauelementes in wenigstens zwei, insbesondere in vier weitere Leiterrahmenabschnitte und in vier Leitungselemente aufgeteilt. Auf diese Weise wird die Herstellung von mehreren Leitungselementen und mehreren weiteren Leiterrahmenabschnitten vereinfacht.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden. Dabei zeigen in jeweils schematisierter Darstellung
- Fig. 1: einen schematischen Teilausschnitt eines Leiterrahmens mit mehreren Leiterrahmenabschnitten und Verbindungsstrukturen;
- Fig. 2: eine perspektivische Darstellung eines Leiterrahmenabschnittes mit Verbindungsstrukturen und weiteren Leiterrahmenabschnitten eines Bauelementes;
- Fig. 3: eine schematische Darstellung des Teilausschnittes des Leiterrahmens nach der Montage von Halbleiterchips auf den Leiterrahmenabschnitten und von Leitungselementen auf den weiteren Leiterrahmenabschnitten;
- Fig. 4: eine perspektivische Darstellung des Leiterrahmenabschnittes, der Verbindungsstrukturen, der weiteren Leiterrahmenabschnitte, der Halbleiterchips und der Leitungselemente eines Bauelementes nach dem Einbetten in das Gehäuse;
- Fig. 5: eine schematische Ansicht von oben auf Fig. 4;
- Fig. 6: eine schematische Ansicht von unten auf Fig. 4;
- Fig. 7: eine perspektivische Ansicht eines Teilausschnittes des Leiterrahmens mit Blick auf die Rückseite, wobei die Verbindungsstrukturen von den weiteren Leiterrahmenabschnitten getrennt sind;
- Fig. 8: eine schematische Darstellung des Leiterrahmens mit Blick auf eine Oberseite, wobei die Halbleiterchips über elektrische Leitungen mit den Leitungselementen kontaktiert sind;
- Fig. 9: eine perspektivische Ansicht einer weiteren Ausführungsform eines Leiterrahmens, wobei auf weitere Leiterrahmenabschnitte und Leitungselemente verzichtet wurde;
- Fig. 10: in einer schematischen Darstellung eine Ansicht eines Teilausschnittes der Fig. 9 ohne Leitungen;
- Fig. 11: die Unterseite der Anordnung der Fig. 10;
- Fig. 12: in einer perspektivischen Ansicht die Anordnung der Fig. 10;
- Fig. 13: in einer schematischen Darstellung eine Oberseite eines Leiterrahmens mit Halbeiterchips, Kontaktpads, Leitungselementen und Leitungen in einer teilweise transparenten Darstellung;
- Fig. 14: einen Querschnitt durch die Anordnung der Fig. 13;
- Fig. 15: eine schematische Explosionsdarstellung eines Dau Bauelementes, das nicht under der beanspruchten Erfindung fällt;
- Fig. 16: eine schematische Explosionsdarstellung des Bauelementes der Fig. 15 von unten;
- Fig. 17: eine perspektivische Darstellung einer wei-teren Ausführung eines Bauelementes, das nicht under der beanspruchten Erfindung fällt;
- Fig. 18: eine Draufsicht von unten auf das Bauelement der Fig. 17;
- Fig. 19: eine schematische Darstellung einer Anordnung mit mehreren Bauelementen; und
- Fig. 20: eine Draufsicht von unten auf die Anordnung der Fig. 19.

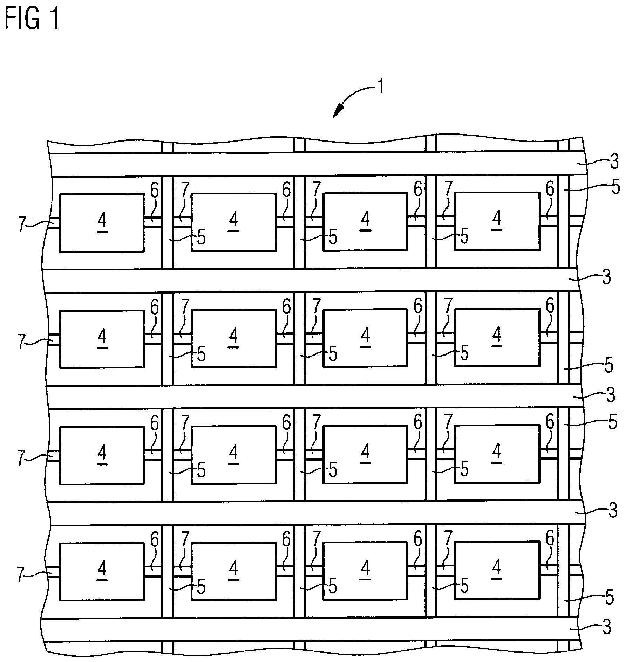

Hierbei bilden die Figuren 1-6, 8, und 13-14 zusammen ein Verfahren zum Herstellen eines optoelektronischen Bauelementes mit wenigstens einem optoelektronischen Halbleiterchip, das unter der beanspruchten Erfindung fällt.

Fig. 1 zeigt in einer schematischen Darstellung einen Ausschnitt eines Leiterrahmens 1, der parallel angeordnete Streifen 3 aufweist, wobei zwischen jeweils zwei Streifen 3 eine Reihe von Kontaktpads 4 angeordnet ist. Zwischen jeweils zwei Kontaktpads 4 ist ein Verbindungssteg 5 vorgesehen, der zwei benachbarte Streifen 3 miteinander verbindet. Jeder Verbindungssteg 5 ist zusätzlich mit zwei weiteren Verbindungsstegen 6, 7 mit gegenüberliegenden Kontaktpads 4 einer Reihe verbunden.

Die Kontaktpads 4 sind in der dargestellten Ausführungsform quadratisch ausgebildet. Die Kontaktpads 4 weisen in der dargestellten Ausführungsform eine etwa doppelt so große Breite wie die Streifen 3 auf. Die Verbindungsstege 5 weisen in der dargestellten Ausführungsform eine kleinere Breite und/oder eine kleinere Höhe als die Streifen 3 auf. Die Kontaktpads 4 weisen in der dargestellten Ausführungsform eine gleiche Höhe wie die Streifen 3 auf. Abhängig von der gewählten Ausführungsform kann die Höhe der Kontaktpads 4 auch von der Höhe der Streifen 3 abweichen. Zudem kann das Verhältnis der Geometrien der Streifen 3 und der Kontaktpads 4 auch anders gewählt werden. Der Leiterrahmen 1 umfasst ein elektrisch leitfähiges Material, zum Beispiel Kupfer, oder ist aus einem elektrisch leitenden Material, zum Beispiel Kupfer, gebildet. Zudem kann abhängig von der gewählten Ausführungsform die Anordnung der Kontaktpads, der Verbindungsstege und der weiteren Verbindungsstege auch anders angeordnet sein.

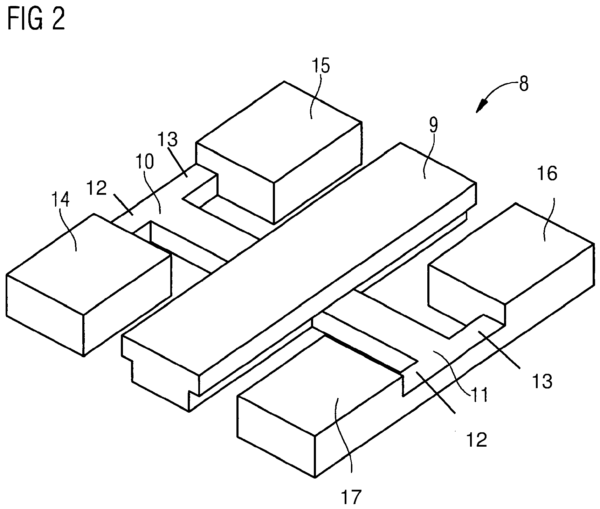

Fig. 2 zeigt in einer perspektivischen Darstellung ein Teilstück 8 des Leiterrahmens 1, das beispielsweise zur Ausbildung eines Bauelementes verwendet wird. Das Teilstück 8 weist einen Leiterrahmenabschnitt 9 auf, der aus einem Teilstück eines Streifens 3 gebildet ist. Zudem weist das Teilstück 8 jeweils zwei Teilstücke 10, 11 auf, die Teil von zwei Verbindungsstegen 5 darstellen. Weiterhin weist das Teilstück 8 zwei Teilstücke 12, 13 von weiteren Verbindungsstegen 6, 7 auf. Weiterhin weist das Teilstück 8 vier Teilstücke 14 bis 17 von vier Kontaktpads 4 auf. In der dargestellten Ausführungsform des Teilstückes 8 wird beim Auftrennen des Leiterrahmens 1 jedes der Kontaktpads 4 in vier Teilstücke 14,15,16,17 aufgeteilt. Die Teilstücke 10, 11 der Verbindungsstege und die Teilstücke 12, 13 der weiteren Verbindungsstege stellen eine Versteifungsstruktur dar. Die Teilstücke 14, 15, 16, 17 der Kontaktpads 4 stellen weitere Leiterrahmenabschnitte dar, die ebenfalls eine Versteifungsstruktur darstellen.

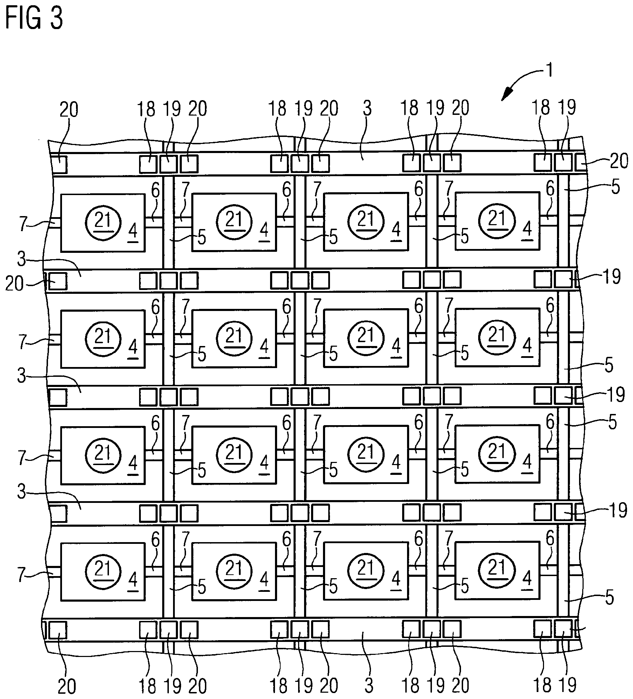

Fig. 3 zeigt in einer schematischen Darstellung einen Ausschnitt des Leiterrahmens 1, wobei auf die Streifen 3 zwischen zwei Kontaktpads 4 jeweils drei Halbleiterchips 18, 19, 20 angeordnet sind. Zudem ist auf jedem Kontaktpad 4 mittig ein Leitungselement 21 angeordnet. Das Leitungselement 21 weist beispielsweise die gleiche Höhe wie die Halbleiterchips 18, 19, 20 auf. Abhängig von der gewählten Ausführungsform können auch mehr oder weniger Halbleiterchips auf den Streifenabschnitten zwischen zwei Kontaktpads 4 angeordnet werden. Zudem können abhängig von der gewählten Ausführungsform auf einem Kontaktpad 4 auch mehrere Leitungselemente 21 beispielsweise in den vier Eckbereichen angeordnet werden.

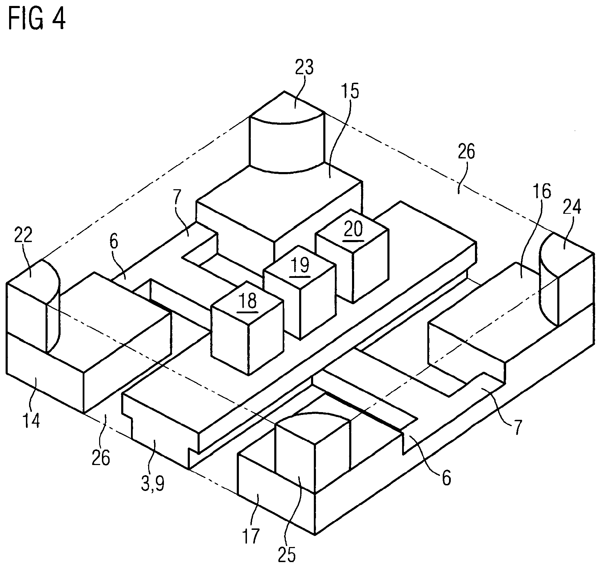

Nach der Montage der Halbleiterchips 18, 19, 20 und der Leitungselemente 21, wie in Fig. 3 dargestellt ist, wird der Leiterrahmen 1 in einen Gehäusewerkstoff 26 eingebettet, wie in einem Ausschnitt in Fig. 4 dargestellt.

Fig. 4 zeigt in einer perspektivischen Darstellung ein aus dem Leiterrahmen der Figur 3 herausgeschnittenes Teilstück 8, wobei die drei Halbleiterchips 18, 19, 20 und vier Teilstücke 22, 23, 24, 25 der Leitungselemente 21 von vier benachbarten Kontaktpads 4 dargestellt sind. Jedes der Teilstücke 22, 23, 24, 25 der Leitungselemente 21 stellt jeweils für sich ein Leitungselement dar. Die Anordnung der Fig. 4 kann für die Ausbildung eines Bauelementes verwendet werden.

Die Halbleiterchips 18, 19, 20 stellen optoelektronische Halbleiterchips dar, die beispielsweise in Form von Leuchtdiodenchips (LED-Chips) oder in Form von lichtabsorbierenden Halbleiterchips, beispielsweise Fotodiodenchips, ausgebildet sind. Die Halbleiterchips 18, 19, 20 können identisch oder unterschiedlich ausgebildet sein. Abhängig von der gewählten Ausführungsform können auf einem Leiterrahmenabschnitt 9 ein Leuchtdiodenchip und ein Fotodiodenchip angeordnet sein. Der Leuchtdiodenchip kann ausgebildet sein, um eine elektromagnetische Strahlung beliebiger Wellenlänge zu emittieren. Zudem können auf einem Leiterrahmenabschnitt 9 Leuchtdiodenchips angeordnet sein, die zur Emission elektromagnetischer Strahlung mit unterschiedlicher Wellenlänge ausgebildet sind. Beispielsweise kann ein Leiterrahmenabschnitt 9 einen Leuchtdiodenchip mit blauem Licht, einen Leuchtdiodenchip mit rotem Licht und einen Leuchtdiodenchip mit grünem Licht aufweisen. Die Halbleiterchips 18, 19, 20 weisen beispielsweise auf einer Unterseite, die mit dem Leiterrahmenabschnitt 9 verbunden ist, einen ersten elektrischen Anschluss auf. Zudem weisen die Halbleiterchips 18, 19, 20 auf einer Oberseite, die gegenüberliegend zur Unterseite angeordnet ist, einen zweiten elektrischen Anschluss auf. Die Leitungselemente 21 sind aus einem elektrisch leitenden Material gebildet oder weisen ein elektrisch leitendes Material auf.

Der Gehäusewerkstoff 26 ist aus einem elektrisch isolierenden Material gebildet. Der Gehäusewerkstoff kann beispielsweise einen oder mehrere der folgenden Materialien aufweisen oder daraus bestehen: Silikon, Epoxid, Polyphthalamid, Polycyclohexylendimethylenterephthalat (PCT), Kunststoffmaterial, Epoxidharz, Kleber oder ein anderes Formmaterial (Moldmaterial). Der Gehäusewerkstoff 26 kann beispielsweise durch ein Formverfahren (Moldverfahren) auf den Leiterrahmen 1 aufgebracht werden. Insbesondere kann ein Formpressen (compression molding) oder ein Spritzpressen (Transfermolding), insbesondere ein folienunterstützes Spritzpressen (film-assisted transfermolding) verwendet werden. Dabei wird ein Leiterrahmen 1 erhalten, der in den Gehäusewerkstoff 26 eingebettet ist.

Abhängig von der gewählten Ausführungsform kann eine elektrisch leitende Verbindung zwischen dem Leiterrahmenabschnitt 9 und den Teilstücken 22, 23, 24, 25 unterbunden werden. Dabei kann beispielsweise von der Rückseite her ein Teilabschnitt 27 der Teilstücke 10, 11 der Verbindungsstege entfernt werden.

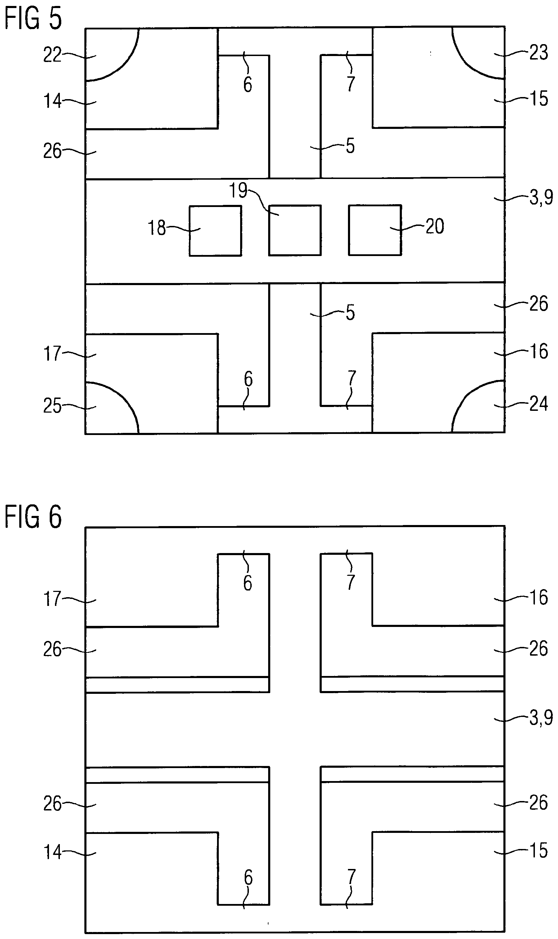

Fig. 5 zeigt eine Ansicht von oben auf den Teilausschnitt der Fig. 4. Fig. 6 zeigt eine Ansicht von unten auf die Anordnung der Fig. 4. Abhängig von der gewählten Ausführungsform können die Leiterrahmenabschnitte mehr oder weniger Leitungselemente und/oder Halbleiterchips aufweisen.

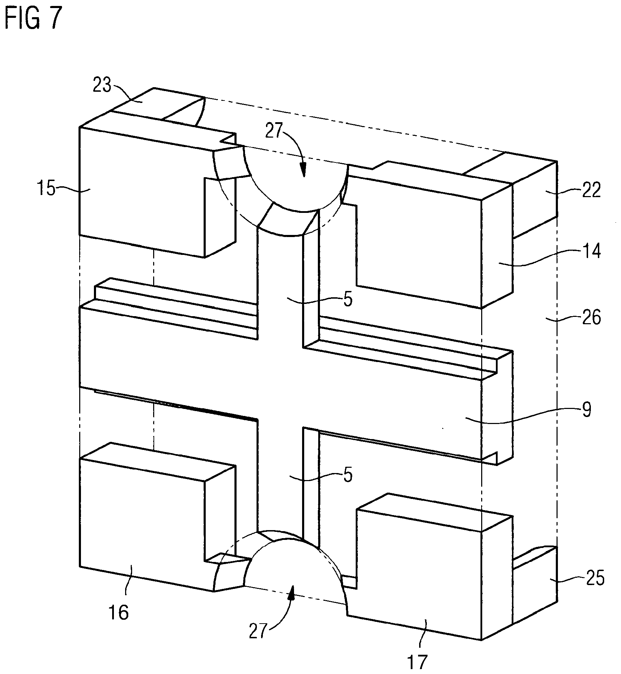

Fig. 7 zeigt einen Teilausschnitt einer Rückseite des Leiterrahmens 1, der in den Gehäusewerkstoff 26 eingebettet ist, wobei die elektrisch leitende Verbindung zwischen den Teilstücken 10, 11 der Verbindungsstege und den Teilstücken 14, 15, 16, 17 der Kontaktpads unterbrochen ist. Zum Entfernen der Teilabschnitte 27 von den Teilstücken 10, 11 der Verbindungsstege können nasschemische oder trockenchemische Ätzverfahren verwendet werden. Fig. 7 zeigt ein Teilstück 8 des Leiterrahmens, das in den Gehäusewerkstoff 26 eingebettet ist. Abhängig von der gewählten Ausführungsform können unterschiedliche Teilstücke der Kontaktpads gegenüber dem Leiterrahmenabschnitt 9 elektrisch isoliert werden, indem ein Teilabschnitt 27 des Verbindungssteges 5 entfernt wird. Dadurch sind die Teilstücke 14 bis 17 der Kontaktpads 4 und die damit verbundenen Teilstücke 22,23,24,25 von dem Leiterrahmenabschnitt 9 getrennt.

Abhängig von der gewählten Ausführung können auch einzelne Teilstücke 14,15,16,17 der Kontaktpads 4 und deren Teilstücke 22,23,24,25 mit dem Leiterrahmenabschnitt 9 elektrisch verbunden bleiben. Insbesondere bei einem Bauelement mit mehreren Teilstücken 8 können unterschiedlichste Konfigurationen von elektrisch leitend verbundenen und elektrisch isolierten Teilstücken von Kontaktpads vorgesehen werden.

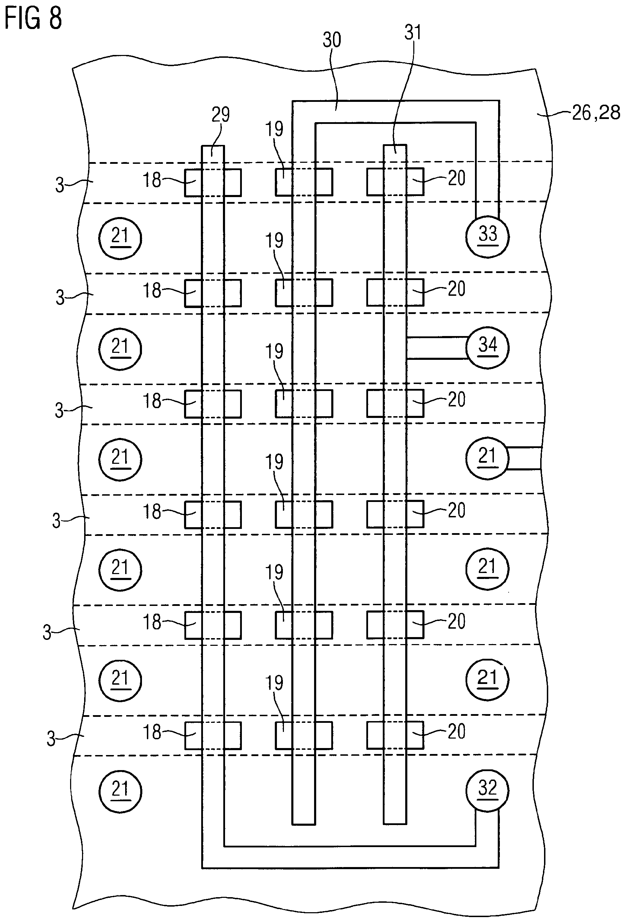

Fig. 8 zeigt eine Sicht auf einen Teilausschnitt einer Oberseite des Leiterrahmens 1, der gemäß Fig. 4 in den Gehäusewerkstoff 26 eingebettet ist. Auf die Oberseite des Gehäuses 28, das durch den ausgehärteten Gehäusewerkstoff 26 gebildet ist, werden drei elektrische Leitungen 29, 30, 31 auf die Oberseite des Gehäuses 28 aufgebracht. In der dargestellten Ausführungsform sind die elektrischen Leitungen 29, 30, 31 senkrecht zu den Streifen 3 angeordnet, wobei die Streifen 3 gestrichelt dargestellt sind. Die Halbleiterchips 18,19,20 und die Leitungselemente 21 sind bis zur Oberseite des Gehäusewerkstoffes 26 geführt. Zudem ist jede der elektrischen Leitungen 29,30,31 jeweils mit einem Halbleiterchip eines Streifens 3 elektrisch leitend verbunden. Dazu sind die elektrischen Leitungen 29,30,31 jeweils mit einem elektrischen Anschluss der Oberseite der Halbleiterchips 18, 19, 20 elektrisch verbunden. Zudem sind die drei elektrischen Leitungen 29,30,31 mit drei verschiedenen Leitungselementen elektrisch leitend verbunden. Die erste elektrische Leitung 29 ist mit einem ersten elektrischen Leitungselement 32 elektrisch leitend verbunden. Eine zweite, mittlere elektrische Leitung 30 ist mit einem zweiten elektrischen Leitungselement 33 elektrisch leitend verbunden. Eine dritte elektrische Leitung 31 ist elektrisch leitend mit einem dritten elektrischen Leitungselement 34 verbunden. Mithilfe der elektrischen Leitungen 29, 30, 31 wird der elektrische Anschluss von der Oberseite der Halbleiterchips 18,19,20 über die elektrischen Leitungen 29,30,31 und die elektrischen Leitungselemente 32,33, 34 auf die Rückseite des Gehäuses 28 des Leiterrahmens 1 geführt. Das Gehäuse 28 weist eine Vielzahl dieser Leitungsanordnungen mit jeweils drei parallelen elektrischen Leitungen 29,30,31 auf, die nebeneinander angeordnet sind. Die Art der Anordnung der elektrischen Leitungen 29, 30, 31 und die Verbindung mit den Halbleiterchips 18,19,20 des Leiterrahmens 1 kann abhängig von dem Aufbau des Bauelementes unterschiedlich gewählt werden.

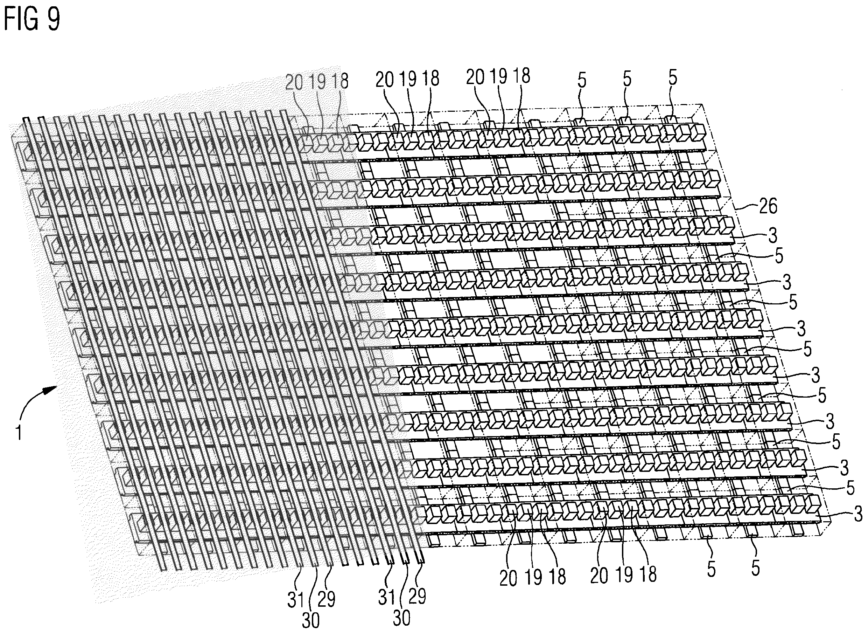

Fig. 9 zeigt in einer perspektivischen Darstellung eine Ausbildungsform eines Leiterrahmens 1, der aus Streifen 3 besteht, die parallel zueinander angeordnet sind, wobei die Streifen 3 über Verbindungsstege 5 miteinander verbunden sind. In dieser Ausführungsform sind keine Kontaktpads zwischen den Streifen 3 angeordnet. Auf die Streifen 3 sind drei Halbleiterchips 18,19,20 angeordnet. Auf einer linken Seite der Fig. 9 sind bereits drei elektrische Leitungen 29, 30, 31 dargestellt. Die elektrischen Leitungen sind senkrecht zu den Streifen 3 angeordnet. Zudem ist jede elektrische Leitung 29, 30, 31 jeweils mit einem Halbleiterchip eines Streifens 3 verbunden. Der Leiterrahmen 1 ist auch in den Gehäusewerkstoff 26 eingebettet, der in der Darstellung der Fig. 9 transparent dargestellt ist. Durch einen entsprechenden Vereinzelungsschritt können Teilausschnitte der Anordnung der Fig. 9 abgetrennt werden, wobei bei dieser Ausführungsform eine elektrische Kontaktierung der elektrischen Leitungen 29, 30, 31 über weitere nicht dargestellte Bauteile erfolgt.

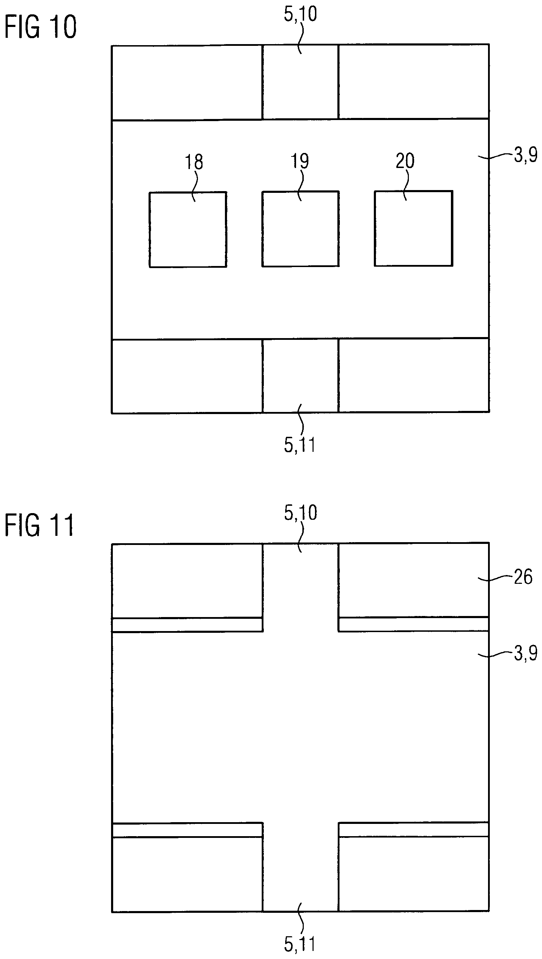

Fig. 10 zeigt einen Teilausschnitt der Anordnung der Fig. 9 vor dem Aufbringen der elektrischen Leitungen. Das Teilstück weist ein Stück eines Streifens 3, drei Halbleiterchips 18, 19, 20 und zwei Teilstücke 10, 11 der Verbindungsstege auf.

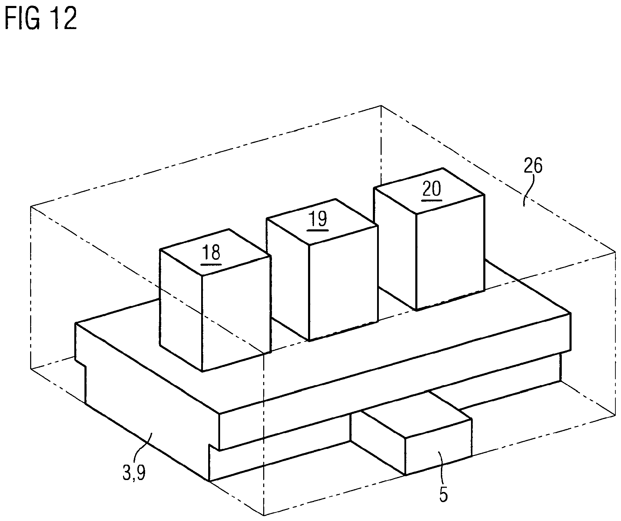

Fig. 11 zeigt eine Ansicht von unten auf das Teilstück der Fig. 10. Fig. 12 zeigt eine perspektivische Darstellung des parent dargestellt ist. Das Stück des Streifens 3 weist in der dargestellten Ausführungsform eine seitlich abgestufte Kontur auf, die eine bessere Haftung im Gehäusewerkstoff 26 ermöglicht. Zudem ist deutlich zu erkennen, dass die Teilstücke 10, 11 eine geringere Höhe und eine geringere Breite als das Stück des Streifens 3 aufweisen. Die in den Figuren 10 bis 12 dargestellte Ausführung kann nach entsprechendem Versehen mit elektrischen Leitungen als optoelektronisches Bauelement betrieben werden. Das in den Figuren 10 bis 12 dargestellte Stück des Streifens 3 stellt einen Leiterrahmenabschnitt 9 dar.

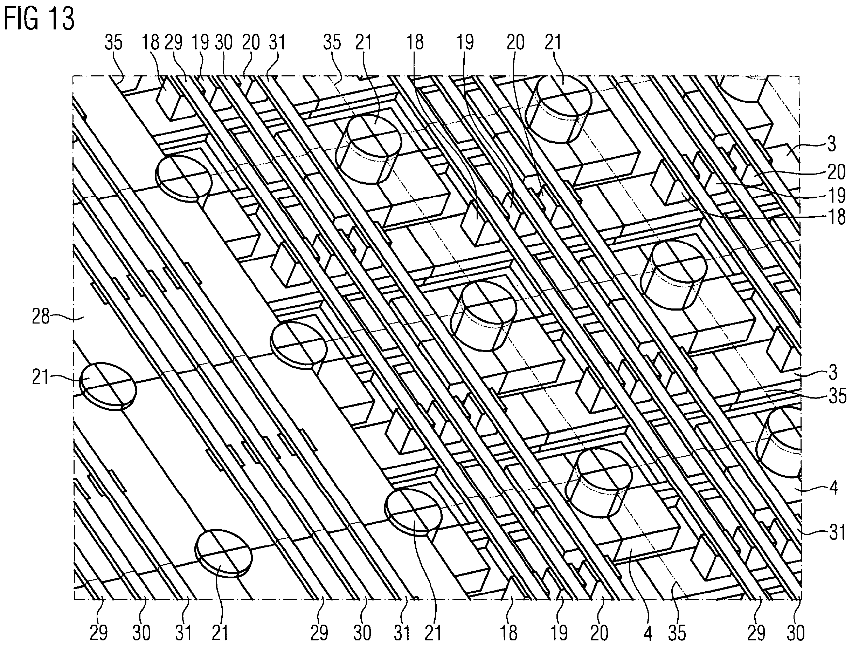

Fig. 13 zeigt in einer vergrößerten Darstellung die Anordnung der Fig. 4 nach dem Aufbringen der elektrischen Leitungen, wobei in einem rechten Bereich der Fig. 13 das Gehäuse 28 transparent dargestellt ist. Zudem sind Schnittkanten 35 schematisch dargestellt, die das Teilstück für ein späteres optoelektronisches Bauelement darstellen.

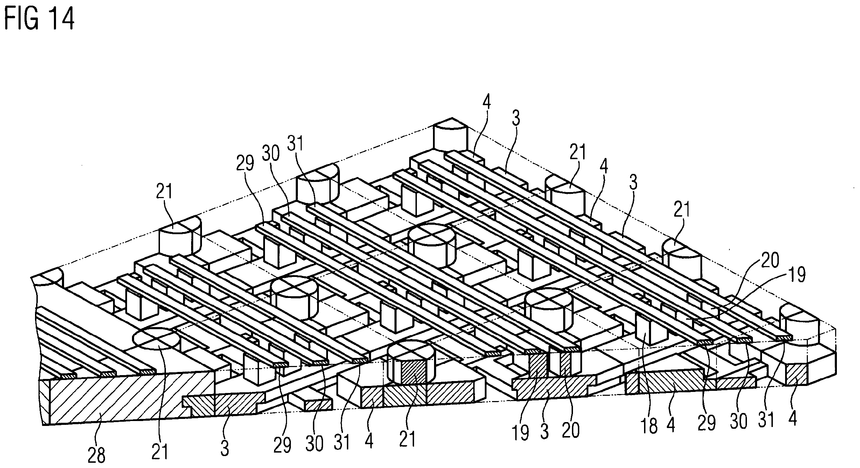

Fig. 14 zeigt einen Querschnitt durch die Anordnung der Fig. 13. Dabei ist das Gehäuse 28 in großen Bereichen transparent dargestellt.

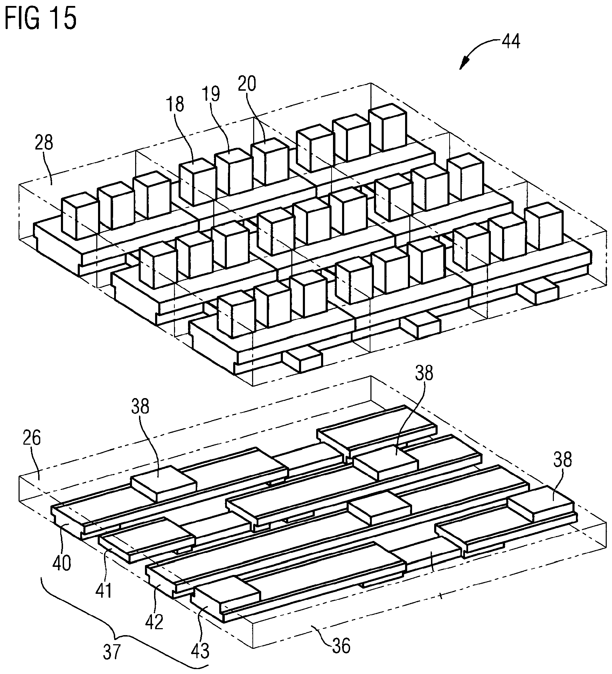

Fig. 15 zeigt in einer perspektivischen teiltransparenten Darstellung ein optoelektronisches Bauelement 44, das nicht unter der beanspruchten Erfindung fällt, mit 3 x 3 Teilstücken 8. In der gewählten Darstellung sind die elektrischen Leitungen nicht dargestellt. Zudem zeigt Fig. 15 eine Ausbildungsform, bei der auf die Ausbildung von Kontaktpads und Leitungselementen verzichtet wurde. Abhängig von der gewählten Ausführungsform kann das optoelektronische Bauelement auch Kontaktpads und Leitungselemente, gemäß der beanspruchten Erfindung, wie in Fig. 13 dargestellt, aufweisen. Auf einer Unterseite des optoelektronischen Bauelementes 44 ist ein weiteres Gehäuse 36 angeordnet. Das weitere Gehäuse 36 weist eine Leitungsstruktur 37 auf, die in einen Gehäusewerkstoff 26 der elektrisch isolierend ist, eingebettet ist.Die Leitungsstruktur 37 grenzt an vorgegebenen Kontaktstellen 38 an die Oberseite des weiteren Gehäuses 36. Somit kann über diese Kontaktstellen 38 eine elektrisch leitende Kontaktierung mit der Unterseite der Leiterrahmenabschnitte 9 des Bauelementes erreicht werden. Zudem weist die Leitungsstruktur 37 in der dargestellten Ausführungsform vier parallel zueinander angeordnete weitere elektrische Leitungen 40, 41, 42, 43 auf. Die weiteren Leitungen können unterschiedliche Breiten und/oder Dicken aufweisen. Zudem können die weiteren elektrischen Leitungen 40,41,42,43 auch teilweise miteinander verbunden sein. Das weitere Gehäuse 36 kann bei allen Ausführungsformen auch einteilig mit dem Gehäuse 28 ausgebildet sein.

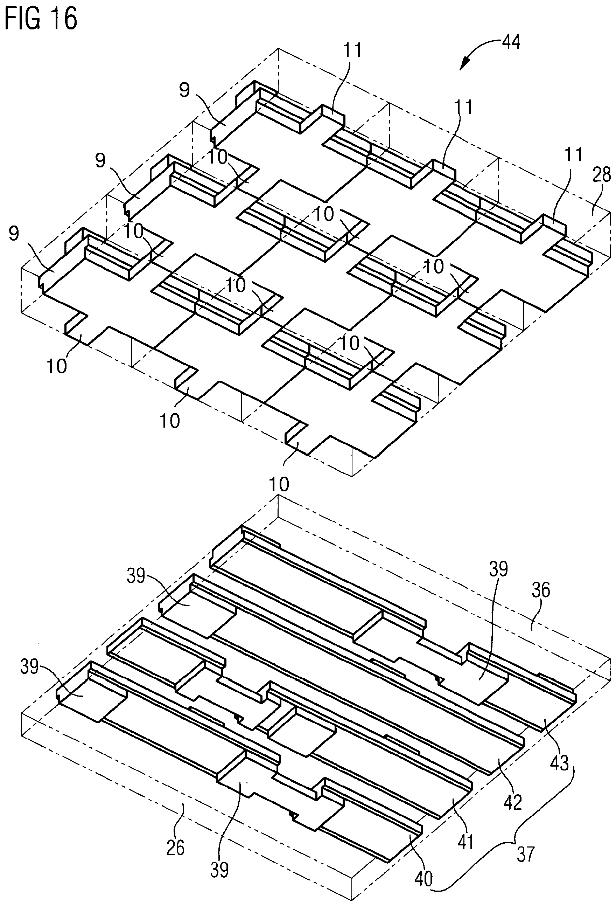

Fig. 16 zeigt in einer perspektivischen und teiltransparenten Darstellung die Anordnung der Fig. 15, wobei auf der Unterseite des weiteren Gehäuses 36 die Leitungsstruktur 37 an weiteren Kontaktstellen 39 an die Unterseite des weiteren Gehäuses 36 angrenzt. Auf diese Weise kann eine elektrische Kontaktierung der Leitungsstruktur 37 von der Unterseite des weiteren Gehäuses 36 erfolgen. Die Ausführungsform des Bauelements ohne die Verwendung von Kontaktpads ermöglicht eine weitere Miniaturisierung der Anordnung der Halbleiterchips. Abhängig von der gewählten Ausführungsform können im weiteren Gehäuse 36 auch eine elektronische Schaltung und/oder ein optoelektronischer Halbleiterchip angeordnet sein. Das weitere Gehäuse 36 kann beispielsweise einen Treiberchip, einen Sensorchip, insbesondere beispielsweise einen Temperatursensorchip, einen Helligkeitssensorchip, einen Farbsensorchip, einen Speicherchip, insbesondere beispielsweise einen Nurlesespeicherchip oder einen wiederbeschreibbaren Speicherchip, oder einen ESD-Schutzchip aufweisen.

Abhängig von der gewählten Ausführung kann anstelle des weiteren Gehäuses 36 mit der Leitungsstruktur 37 für eine gewünschte elektrische Verdrahtung der drei Halbleiterchips 18,19,20 des optoelektronischen Bauelementes 44 eine entsprechende Schichtstruktur mit elektrisch leitenden und elektrisch isolierenden Schichten auf die Unterseite des optoelektronischen Bauelementes 44 aufgebracht werden.

Auf diese Weise kann die gewünschte Verdrahtung auch realisiert werden.

Die Schichtstruktur weist eine Leitungsstruktur auf, die vorgegebene Kontaktstellen an einer Oberseite und an einer Unterseite aufweist. Somit kann über die Kontaktstellen an der Oberseite eine elektrisch leitende Kontaktierung mit der Unterseite der Leiterrahmenabschnitte 9 des Bauelementes erreicht werden. Die Kontaktstellen an der Unterseite dienen zur elektrischen Kontaktierung des Bauelementes.

Dazu wird beispielsweise eine vollflächige erste Metallisierungsschicht auf die Rückseite des optoelektronischen Bauelementes 44 aufgebracht, wobei die erste Metallisierungsschicht gemäß der gewünschten elektrischen Leitungsführung strukturiert wird und die Kontaktstellen aufweist. Dann wird eine vollflächige erste Passivierungsschicht auf die strukturierte erste Metallisierungsschicht aufgebracht. Dann wird die erste Passivierungsschicht strukturiert. Des Weiteren kann eine vollflächige zweite Metallisierungsschicht auf die strukturierte erste Passivierungsschicht aufgebracht werden. Die zweite Metallisierungsschicht wird strukturiert und es wird eine vollflächige zweite Passivierungsschicht auf die strukturierte zweite Metallisierungsschicht aufgebracht. Dann kann wiederum die zweite Passivierungsschicht strukturiert werden usw. Auf der Unterseite der Schichtstruktur werden mit einer Metallisierungsschicht die Kontaktstellen der Unterseite ausgebildet. Mit dieser Schichtstruktur können verschiedenste elektrische Leitungsverbindungen für die Halbleiterchips realisiert werden.

Zudem können in der Schichtstruktur auch eine elektronische Schaltung und/oder ein optoelektronischer Halbleiterchip angeordnet sein. Die Schichtstruktur kann beispielsweise einen Treiberchip, einen Sensorchip, insbesondere einen Temperatursensorchip, einen Helligkeitssensorchip, einen Farbsensorchip, einen Speicherchip, insbesondere einen Nurlesespeicherchip oder einen wiederbeschreibbaren Speicherchip, oder einen ESD-Schutzchip aufweisen.

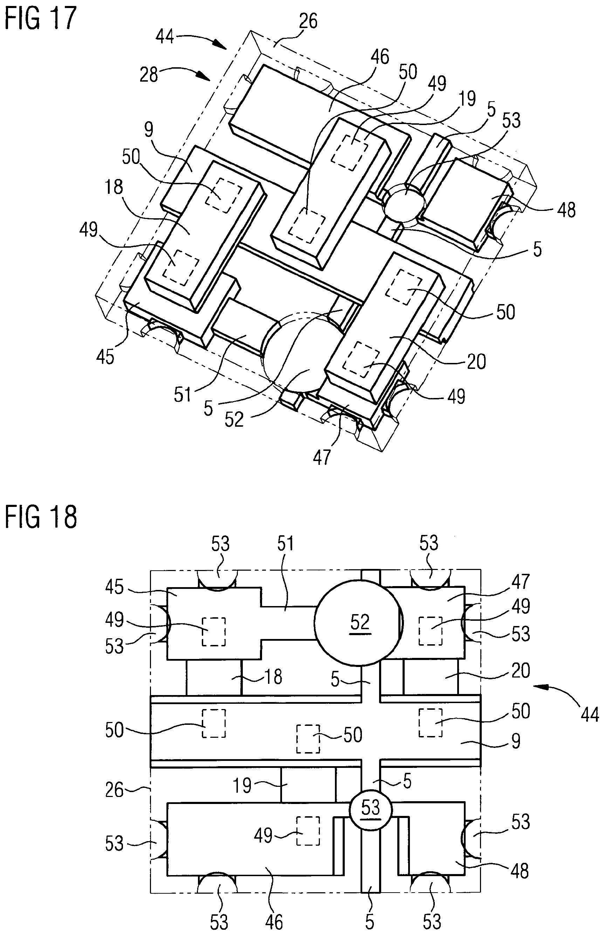

Fig. 17 zeigt eine weitere Ausführung eines optoelektronischen Bauelementes 44, das nicht unter der beanspruchten Erfindung fällt, mit einem Gehäuse 28 mit drei Halbleiterchips 18,19,20, die in diesem Beispiel jeweils zwei elektrische Anschlüsse 49, 50 auf Unterseiten aufweisen. Weiterhin weist das optoelektronische Bauelement 44 einen Leiterrahmenabschnitt 9 und vier weitere Leiterrahmenabschnitte 45,46,47,48 auf. Die elektrischen Anschlüsse 49, 50 sind schematisch mithilfe von gestrichelten Linien dargestellt. Die zwei elektrischen Anschlüsse 49,50 eines Halbleiterchips 18,19,20 sind jeweils mit zwei verschiedenen Leiterrahmenabschnitten 9,45,46,47 verbunden. In dem gezeigten Beispiel ist jeweils der zweite elektrische Anschluss 50 der Halbleiterchips 18,19,20 mit dem Leiterrahmenabschnitt 9 verbunden. Der erste elektrische Anschluss 49 des ersten Halbleiterchips 18 ist mit dem ersten weiteren Leiterrahmenabschnitt 45 verbunden, der erste elektrische Anschluss 49 des zweiten Halbleiterchips 19 ist mit dem zweiten weiteren Leiterrahmenabschnitt 46 verbunden, und der erste elektrische Anschluss 49 des dritten Halbleiterchips 20 ist mit dem dritten weiteren Leiterrahmenabschnitt 47 verbunden.

. Auf diese Weise kann jeder weitere Leiterrahmenabschnitt 45,46,47 mit einem anderen Potential verbunden sein und unabhängig von den anderen weiteren Leiterrahmenabschnitten 45,46,47 bestromt werden.

Beispielsweise kann der Leiterrahmenabschnitt 9 mit Massepotential verbunden sein. Die weiteren Leiterrahmenabschnitte 45,46,47 können mit verschiedenen oder gleichen positiven Spannungspotentialen verbunden sein. Die Leiterrahmenabschnitte 9,45,46,47,48 können ursprünglich über die Verbindungsstege 5 und weitere Verbindungsstege 51 miteinander einteilig in Form eines Leiterrahmens ausgebildet gewesen sein, bevor die Verbindungsstege 5,51 aufgetrennt wurden.

Schematisch sind zwei Trennabschnitte 52,53 als Kreisringe dargestellt. Beispielsweise können die Trennabschnitte 52,53 mithilfe von Stanzwerkzeugen oder mithilfe eines Lasers oder mithilfe eines Ätzverfahrens in die Verbindungsstege 5,51 eingebracht werden.

Abhängig von der gewählten Ausführung können die ersten elektrischen Anschlüsse 49 der Halbleiterchips 18,19,20 auch nur auf dem ersten weiteren Leiterrahmenabschnitt 45 angeordnet sein und mit dem ersten weiteren Leiterrahmenabschnitt 45 elektrisch leitend verbunden sein. Bei dieser Ausführung ist keine getrennte Ansteuerung der einzelnen Halbleiterchips 18,19,20 möglich.

Jeder der Leiterrahmenabschnitte 9,45,46,47,48 kann mit einer Versteifungsstruktur in Form eines Teilstückes eines Verbindungssteges 5, 51 verbunden sein.

Die Leiterrahmenabschnitte 9,45,46,47,48, die Verbindungsstege 5, 51 und die Halbleiterchips 18,19,20 sind in den Gehäusewerkstoff 26 eingebettet. Der Gehäusewerkstoff 26 ist transparent dargestellt und bildet das Gehäuse 28. Der Gehäusewerkstoff 26 weist die zu den vorhergehenden Beispielen erläuterten Eigenschaften auf. Der Gehäusewerkstoff 26 kann transparent für elektromagnetische Strahlung sein. Zudem können die Oberseiten der Halbleiterchips und die Unterseiten der Leiterrahmenabschnitte 9,45,46,47,48 frei von dem Gehäusewerkstoff sein.

Die Halbleiterchips 18, 19, 20 stellen optoelektronische Halbleiterchips dar, die beispielsweise in Form von Leuchtdiodenchips (LED-Chips) oder in Form von lichtabsorbierenden Halbleiterchips, beispielsweise Fotodiodenchips, ausgebildet sind. Die Halbleiterchips 18, 19, 20 können identisch oder unterschiedlich ausgebildet sein. Abhängig von der gewählten Ausführungsform können auf einem Leiterrahmenabschnitt 9 ein Leuchtdiodenchip und ein Fotodiodenchip angeordnet sein. Der Leuchtdiodenchip kann ausgebildet sein, um eine elektromagnetische Strahlung beliebiger Wellenlänge zu emittieren. Zudem können in einem Bauelement mehr als drei oder weniger als drei Halbeiterchips angeordnet sein. Insbesondere können in einem Bauelement Leuchtdiodenchips angeordnet sein, die zur Emission elektromagnetischer Strahlung mit unterschiedlicher Wellenlänge ausgebildet sind. Beispielsweise kann ein Bauelement einen Leuchtdiodenchip mit blauem Licht, einen Leuchtdiodenchip mit rotem Licht und einen Leuchtdiodenchip mit grünem Licht aufweisen.

Fig. 18 zeigt die Unterseite des optoelektronischen Bauelementes 44 der Fig. 17.

Die nicht sichtbaren elektrischen Anschlüsse 49,50 der Halbleiterchips 18, 19, 20 sind wieder gestrichelt eingezeichnet. Die elektrische Kontaktierung kann entweder direkt über die Unterseiten der Leiterrahmenabschnitte 9,45,46,47 erfolgen oder es kann noch ein weiteres Gehäuse mit einer Umverdrahtung gemäß den Fig. 15 und 16 vorgesehen sein. Das weitere Gehäuse weist eine Leitungsstruktur auf, die in einen elektrisch isolierenden Gehäusewerkstoff eingebettet ist. Die Leitungsstruktur grenzt an vorgegebenen Kontaktstellen an die Oberseite des weiteren Gehäuses. Somit kann über diese Kontaktstellen eine elektrisch leitende Kontaktierung mit den Unterseiten der Leiterrahmenabschnitte 9,45,46,47 des optoelektronischen Bauelementes 44 erreicht werden. Zudem weist die Leitungsstruktur z.B. mehrere parallel zueinander angeordnete weitere Leitungen auf.

Die weiteren Leitungen können unterschiedliche Breiten und/oder Dicken aufweisen. Zudem können die weiteren Leitungen auch teilweise miteinander verbunden sein.

Abhängig von der gewählten Ausführungsform können im weiteren Gehäuse auch eine elektronische Schaltung und/oder ein optoelektronischer Halbleiterchip angeordnet sein. Das weitere Gehäuse kann beispielsweise einen Treiberchip, einen Sensorchip, insbesondere beispielsweise einen Temperatursensorchip, einen Helligkeitssensorchip, einen Farbsensorchip, einen Speicherchip, insbesondere beispielsweise einen Nurlesespeicherchip oder einen wiederbeschreibbaren Speicherchip, oder einen ESD-Schutzchip aufweisen.

Abhängig von der gewählten Ausführung kann anstelle des weiteren Gehäuses mit der Leitungsstruktur für eine gewünschte elektrische Kontaktierung und/oder Verdrahtung der Halbleiterchips 18,19,20 des optoelektronischen Bauelementes 44 eine entsprechende Schichtstruktur mit elektrisch leitenden und elektrisch isolierenden Schichten auf die Unterseite des optoelektronischen Bauelementes 44 aufgebracht werden. Auf diese Weise kann auch die gewünschte Verdrahtung realisiert werden. Dazu wird beispielsweise eine vollflächige erste Metallisierungsschicht auf die Rückseite des optoelektronischen Bauelementes 44 aufgebracht, wobei die erste Metallisierungsschicht gemäß der gewünschten elektrischen Leitungsführung strukturiert wird. Dann wird eine vollflächige erste Passivierungsschicht auf die strukturierte erste Metallisierungsschicht aufgebracht. Dann kann eine Strukturierung der ersten Passivierungsschicht erfolgen. Des Weiteren kann eine vollflächige zweite Metallisierungsschicht auf die strukturierte erste Passivierungsschicht aufgebracht werden. Die zweite Metallisierungsschicht wird strukturiert und es wird eine vollflächige zweite Passivierungsschicht auf die strukturierte zweite Metallisierungsschicht aufgebracht. Dann kann wiederum die zweite Passivierungsschicht strukturiert werden usw. Mit dieser Schichtstruktur können verschiedenste elektrische Leitungsverbindungen für die Halbleiterchips realisiert werden.

Abhängig von der gewählten Ausführungsform können in der Schichtstruktur auch eine elektronische Schaltung und/oder ein optoelektronischer Halbleiterchip angeordnet sein. Die Schichtstruktur kann beispielsweise einen Treiberchip, einen Sensorchip, insbesondere beispielsweise einen Temperatursensorchip, einen Helligkeitssensorchip, einen Farbsensorchip, einen Speicherchip, insbesondere beispielsweise einen Nurlesespeicherchip oder einen wiederbeschreibbaren Speicherchip, oder einen ESD-Schutzchip aufweisen.

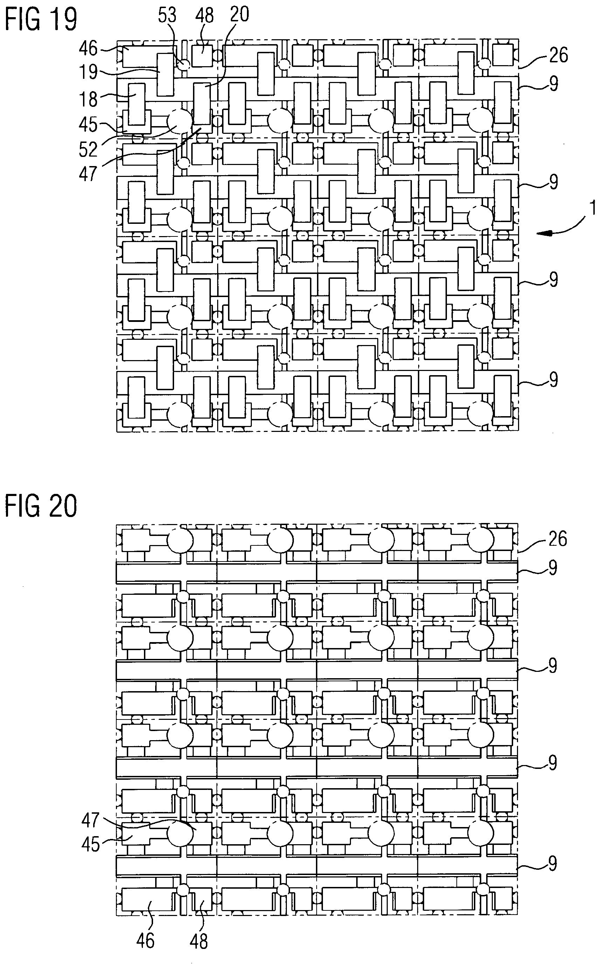

Fig. 19 zeigt eine Anordnung mit einem Leiterrahmen 1, der Leiterrahmenabschnitte 9,45,46,47,48 aufweist, wobei Halbleiterchips 18,19,20 auf den Leiterrahmenabschnitten angeordnet sind und die Halbleiterchips und die Leiterrahmenabschnitte in den Gehäusewerkstoff 26 eingebettet sind. Die Oberseiten der Halbleiterchips 18,19,20 können frei von dem Gehäusewerkstoff 26 sein. Ebenso können die Unterseiten der Leiterrahmenabschnitte 9,45,46,47,48 frei von dem Gehäusewerkstoff 26 sein. Der Leiterrahmen 1 ist noch nicht in einzelne optoelektronische Bauelemente 44 aufgeteilt, wie in den Figuren 17 und 18 dargestellt ist. Jedoch sind die einzelnen Leiterrahmenabschnitte 9,45,46,47,48 schon über Trennabschnitte 52,53 voneinander getrennt.

Fig. 20 zeigt die Unterseite der Anordnung der Fig. 19.

Die optoelektronischen Bauelemente können beispielsweise als SMT-Bauelement für eine Oberflächenmontage ausgebildet sein. Mithilfe des beschriebenen Verfahrens kann ein QFN-Modul bereitgestellt werden. Die optoelektronischen Bauelemente können somit im QFN-Design hergestellt werden, wobei Teile des Leiterrahmens als Armierung und Befestigungsstruktur im Gehäuse verwendet werden. Die Leitungselemente stellen Durchkontaktierungen dar. Abhängig von der gewählten Ausführungsform können die Leitungselemente auch nach dem Ausbilden des Gehäuses in das Gehäuse eingebracht werden. Abhängig von der gewählten Ausführungsform können unterschiedliche Teilausschnitte aus dem Leiterrahmen herausgetrennt werden. Entsprechend der verwendeten Halbleiterchips und der Anzahl der Halbleiterchips des Bauelementes ist die elektrische Kontaktierung mithilfe der Leitungen auszuführen. Die optoelektronischen Bauelemente können beispielsweise verwendet werden, um Videowände oder Videobildschirme zu realisieren. Die Videowände können aus einer Vielzahl von optoelektronischen Bauelementen aufgebaut werden. Ein optoelektronisches Bauelement kann beispielsweise eine 3x3- oder 6x6- oder 9x9- usw. - Anordnung von Leiterrahmenabschnitten mit Halbleiterchips aufweisen.

Das beschriebene optoelektronische Bauelement und das beschriebene Verfahren ermöglichen den Aufbau von optoelektronischen Bauelementen mit einer hohen Packungsdichte von optoelektronischen Halbleiterchips mit einer entsprechenden elektrischen Kontaktierung zur Ansteuerung der Halbleiterchips. Zudem wird ein Halbleiterchip mit einer Versteifungsstruktur bereitgestellt, so dass sehr dünne Leiterrahmen und dünne Gehäuse zur Ausbildung der Bauelemente verwendet werden können.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

### BEZUGSZEICHENLISTE

- 1: Leiterrahmen
- 3: Streifen
- 4: Kontaktpad
- 5: Verbindungssteg
- 6: erster weiterer Verbindungssteg
- 7: zweiter weiterer Verbindungssteg
- 8: Teilstück
- 9: Leiterrahmenabschnitt
- 10: erstes Teilstück Verbindungssteg
- 11: zweites Teilstück Verbindungssteg
- 12: erstes Teilstück weiterer Verbindungssteg
- 13: zweites Teilstück weiterer Verbindungssteg
- 14: erstes Teilstück Kontaktpad
- 15: zweites Teilstück Kontaktpad
- 16: drittes Teilstück Kontaktpad
- 17: viertes Teilstück Kontaktpad
- 18: erster Halbleiterchip
- 19: zweiter Halbleiterchip
- 20: dritter Halbleiterchip
- 21: Leitungselement
- 22: erstes Teilstück Leitungselement
- 23: zweites Teilstück Leitungselement
- 24: drittes Teilstück Leitungselement
- 25: viertes Teilstück Leitungselement
- 26: Gehäusewerkstoff
- 27: Teilabschnitt
- 28: Gehäuse
- 29: erste elektrische Leitung
- 30: zweite elektrische Leitung
- 31: dritte elektrische Leitung
- 32: erstes elektrisches Leitungselement
- 33: zweites elektrisches Leitungselement
- 34: drittes elektrisches Leitungselement
- 35: Schnittkante
- 36: weiteres Gehäuse
- 37: Leitungsstruktur
- 38: Kontaktstelle
- 39: weitere Kontaktstelle
- 40: erste weitere elektrische Leitung
- 41: zweite weitere elektrische Leitung
- 42: dritte weitere elektrische Leitung
- 43: vierte weitere elektrische Leitung
- 44: optoelektronisches Bauelement
- 45: erster weiterer Leiterrahmenabschnitt
- 46: zweiter weiterer Leiterrahmenabschnitt
- 47: dritter weiterer Leiterrahmenabschnitt
- 48: vierter weiterer Leiterrahmenabschnitt
- 49: erster elektrischer Anschluss
- 50: zweiter elektrischer Anschluss
- 51: weiterer Verbindungssteg
- 52: erster Trennabschnitt
- 53: zweiter Trennabschnitt

## Patentansprüche

1. Optoelektronisches Bauelement (44) mit wenigstens einem optoelektronischen Halbleiterchip, mit einem Leiterrahmenabschnitt (9), und mit einer seitlich vom Leiterrahmenabschnitt (9) wegragenden Versteifungsstruktur, wobei der Halbleiterchip (18, 19, 20) auf dem Leiterrahmenabschnitt (9) angeordnet ist, und wobei der Leiterrahmenabschnitt (9), die Versteifungsstruktur, und der Halbleiterchip (18, 19, 20) in einem elektrisch isolierenden Gehäuse eingebettet sind, **dadurch gekennzeichnet, dass** der Leiterrahmenabschnitt (9) über die Versteifungsstruktur mit einem weiteren Leiterrahmenabschnitt verbunden ist, dass ein Leitungselement auf einer Oberseite des weiteren Leiterrahmenabschnittes angeordnet ist, und dass der weitere Leiterrahmenabschnitt und das Leitungselement in dem Gehäuse (28) eingebettet sind.

2. Bauelement nach Anspruch 1, mit einer seitlich vom Leiterrahmenabschnitt (9) wegragenden weiteren Versteifungsstruktur, wobei der Leiterrahmenabschnitt (9) über die weitere Versteifungsstruktur (0) mit wenigstens einem weiteren, weiteren Leiterrahmenabschnitt verbunden ist, wobei ein weiteres Leitungselement auf einer Oberseite des weiteren, weiteren Leiterrahmenabschnittes angeordnet ist, und wobei die weitere Versteifungsstruktur mit dem weiteren, weiteren Leiterrahmenabschnitt und dem weiteren Leitungselement in dem Gehäuse (28) eingebettet sind.

3. Bauelement nach einem der vorhergehenden Ansprüche, wobei auf einer Oberseite des Gehäuses (28) eine elektrische Leitung (29, 30, 31) aufgebracht ist, wobei die elektrische Leitung (29, 30, 31) mit dem wenigstens einen Halbleiterchip (18, 19, 20) elektrisch kontaktiert ist

4. Bauelement nach Anspruch 3, wobei die elektrische Leitung (29, 30, 31) mit wenigstens einem elektrischen Leitungselement (32, 33, 34) des Bauelementes kontaktiert ist.

5. Bauelement nach Anspruch 2, wobei die Versteifungsstruktur und die weitere Versteifungsstruktur und/oder der weitere Leiterrahmenabschnitt und der weitere, weitere Leiterrahmenabschnitt auf gegenüber liegenden Seiten des Leiterrahmenabschnittes (9) angeordnet sind.

6. Bauelement nach Anspruch 1, wobei die Versteifungsstruktur eine kleinere Dicke und/oder eine kleinere Breite als der Leiterrahmenabschnitt (9) aufweist.

7. Bauelement nach einem der Ansprüche 1 oder 2, wobei das Bauelement mit einem weiteren Gehäuse (36) versehen ist, wobei das weitere Gehäuse (36) eine Leitungsstruktur (37) aufweist, und wobei die Leitungsstruktur (37) mit dem Halbleiterchip (18, 19, 20) elektrisch leitend verbunden ist.

8. Verfahren zum Herstellen eines optoelektronischen Bauelementes (44) mit wenigstens einem optoelektronischen Halbleiterchip, wobei ein Leiterrahmen (1) mit mehreren über Versteifungsstrukturen miteinander verbundenen Leiterrahmenabschnitten vorgesehen ist, wobei wenigstens ein Halbleiterchip (18, 19, 20) auf eine Oberseite eines Leiterrahmenabschnittes (9) aufgebracht wird, wobei der Leiterrahmen (1) mit dem Halbleiterchip (18, 19, 20) in einen elektrisch isolierenden Gehäuse eingebettet wird, und wobei der Leiterrahmenabschnitt (9) mit dem Halbleiterchip (18, 19, 20) und wenigstens einer Versteifungsstruktur von dem übrigen Leiterrahmen (1) abgetrennt wird und das Bauelement erhalten wird, wobei der Leiterrahmenabschnitt (9) über eine Versteifungsstruktur mit einem weiteren Leiterrahmenabschnitt verbunden ist, und wobei vor dem Einbetten in das Gehäuse (28) ein Leitungsele-ment (21) auf eine Oberseite des weiteren Leiterrahmenabschnittes aufgebracht wird, und wobei nach dem Einbetten in das Gehäuse (28) der Leiterrahmenabschnitt (9) mit dem Halbleiterchip (18, 19, 20), die wenigstens eine Versteifungsstruktur und der weitere Leiterrahmenabschnitt mit dem Leitungselement (21) von dem übrigen Leiterrahmen (1) abgetrennt wird und das Bauelement erhalten wird, **dadurch gekennzeichnet, dass** der Leiterrahmenabschnitt (9) über die Versteifungsstruktur mit dem weiteren Leiterrahmenabschnitt verbunden ist.

9. Verfahren nach Anspruch 8, wobei der weitere Leiterrahmenabschnitt und das Leitungselement (21) beim Abtrennen eines Bauelementes in wenigstens zwei, insbesondere in vier Leitungselemente und vier weitere Leiterrahmenabschnitte aufgeteilt werden.

10. Verfahren nach einem der Ansprüche 8 oder 9, wobei das Bauelement mit einem weiteren Gehäuse (36) versehen wird, wobei das weitere Gehäuse (36) eine Leitungsstruktur (37) aufweist, und wobei die Leitungsstruktur: (37) mit dem Halbleiterchip (18, 19, 20) elektrisch leitend verbunden wird.

11. Verfahren nach einem der Ansprüche 8 oder 9, wobei der wenigstens eine Halbleiterchip (18, 19, 20) wenigstens auf einer Oberseite einen elektrischen Anschluss aufweist, wobei auf einer Oberseite des Gehäuses (28) eine elektrische Leitung (29, 30, 31) aufgebracht wird, und wobei die elektrische Leitung (29, 30, 31) mit dem elektrischen Anschluss des Halbleiterchips (18, 19, 20) elektrisch kontaktiert wird.

## Claims

1. Optoelectronic component (44) comprising at least one optoelectronic semiconductor chip, comprising a leadframe section (9), and comprising a stiffening structure projecting away laterally from the leadframe section (9), wherein the semiconductor chip (18, 19, 20) is arranged on the leadframe section (9), and wherein the leadframe section (9), the stiffening structure and the semiconductor chip (18, 19, 20) are embedded in an electrically insulating housing, **characterized in that** the leadframe section (9) is connected to a further leadframe section via the stiffening structure, **in that** a conduction element is arranged on a top side of the further leadframe section, and **in that** the further leadframe section and the conduction element are embedded in the housing (28).

2. Component according to Claim 1, comprising a further stiffening structure projecting away laterally from the leadframe section (9), wherein the leadframe section (9) is connected to at least one other further leadframe section via the further stiffening structure, wherein a further conduction element is arranged on a top side of the other further leadframe section, and wherein the further stiffening structure together with the other further leadframe section and the further conduction element are embedded in the housing (28).

3. Component according to any one of the preceding claims, wherein an electrical line (29, 30, 31) is applied on a top side of the housing (28), wherein the electrical line (29, 30, 31) is electrically contacted with the at least one semiconductor chip (18, 19, 20).

4. Component according to Claim 3, wherein the electrical line (29, 30, 31) is contacted with at least one electrical conduction element (32, 33, 34) of the component.

5. Component according to Claim 2, wherein the stiffening structure and the further stiffening structure and/or the further leadframe section and the other further leadframe section are arranged on opposite sides of the leadframe section (9).

6. Component according to Claim 1, wherein the stiffening structure comprises a smaller thickness and/or a smaller width than the leadframe section (9).

7. Component according to any one of Claims 1 and 2, wherein the component is provided with a further housing (36), wherein the further housing (36) comprises a conduction structure (37), and wherein the conduction structure (37) is electrically conductively connected to the semiconductor chip (18, 19, 20).

8. Method for producing an optoelectronic component (44) comprising at least one optoelectronic semiconductor chip, wherein a leadframe (1) comprising a plurality of leadframe sections connected to one another via stiffening structures is provided, wherein at least one semiconductor chip (18, 19, 20) is applied on a top side of a leadframe section (9), wherein the leadframe (1) with the semiconductor chip (18, 19, 20) is embedded into an electrically insulating housing, and wherein the leadframe section (9) with the semiconductor chip (18, 19, 20) and at least one stiffening structure is separated from the rest of the leadframe (1) and the component is obtained, wherein the leadframe section (9) is connected to a further leadframe section via a stiffening structure, and wherein, prior to the embedding into the housing (28), a conduction element (21) is applied on a top side of the further leadframe section, and wherein, after the embedding into the housing (28), the leadframe section (9) with the semiconductor chip (18, 19, 20), the at least one stiffening structure and the further leadframe section with the conduction element (21) are separated from the rest of the leadframe (1) and the component is obtained, **characterized in that** the leadframe section (9) is connected to the further leadframe section via the stiffening structure.

9. Method according to Claim 8, wherein the further leadframe section and the conduction element (21) are divided into at least two, in particular into four conduction elements and four further leadframe sections during the process of separating a component.

10. Method according to any one of Claims 8 and 9, wherein the component is provided with a further housing (36), wherein the further housing (36) comprises a conduction structure (37), and wherein the conduction structure (37) is electrically conductively connected to the semiconductor chip (18, 19, 20).

11. Method according to any one of Claims 8 and 9, wherein the at least one semiconductor chip (18, 19, 20) comprises an electrical terminal at least on a top side, wherein an electrical line (29, 30, 31) is applied on a top side of the housing (28), and wherein the electrical line (29, 30, 31) is electrically contacted with the electrical terminal of the semiconductor chip (18, 19, 20) .

## Revendications

1. Composant optoélectronique (44) comprenant au moins une puce semiconductrice optoélectronique, une section de châssis de connexion (9), et une structure de renforcement qui part de la section de châssis de connexion (9) vers les côtés,
dans lequel la puce semiconductrice (18, 19, 20) est disposée sur la section de châssis de connexion (9), et dans lequel la section de châssis de connexion (9), la structure de renforcement, et la puce semiconductrice (18, 19, 20) sont implantées dans un boîtier électriquement isolant,
**caractérisé en ce que** la section de châssis de connexion (9) est reliée à une autre section de châssis de connexion par l'intermédiaire de la structure de renforcement, **en ce qu'**un élément conducteur est disposé sur une face supérieure de l'autre section de châssis de connexion, et **en ce que** l'autre section de châssis de connexion et l'élément conducteur sont implantés dans le boîtier (28).

2. Composant selon la revendication 1, comprenant une autre structure de renforcement qui part de la section de châssis de connexion (9) vers les côtés, dans lequel la section de châssis de connexion (9) est reliée à au moins une autre section de châssis de connexion supplémentaire par l'intermédiaire de l'autre structure de renforcement, dans lequel un autre élément conducteur est disposé sur une face supérieure de l'autre section de châssis de connexion supplémentaire, et dans lequel l'autre structure de renforcement pourvue de l'autre section de châssis de connexion supplémentaire et de l'autre élément conducteur sont implantés dans le boîtier (28) .

3. Composant selon l'une des revendications précédentes, dans lequel une ligne électrique (29, 30, 31) est appliquée sur une face supérieure du boîtier (28), dans lequel la ligne électrique (29, 30, 31) est en contact électrique avec ladite au moins une puce semiconductrice (18, 19, 20).

4. Composant selon la revendication 3, dans lequel la ligne électrique (29, 30, 31) est mise en contact avec au moins un élément conducteur électrique (32, 33, 34) du composant.

5. Composant selon la revendication 2, dans lequel la structure de renforcement et l'autre structure de renforcement et/ou l'autre section de châssis de connexion et l'autre section de châssis de connexion supplémentaire sont disposées sur des côtés opposés de la section de châssis de connexion (9).

6. Composant selon la revendication 1, dans lequel la structure de renforcement présente une épaisseur inférieure et/ou une largeur inférieure à celle de la section de châssis de connexion (9).

7. Composant selon l'une des revendications 1 ou 2, dans lequel le composant est pourvu d'un autre boîtier (36), dans lequel l'autre boîtier (36) présente une structure conductrice (37), et dans lequel la structure conductrice (37) est reliée de manière électriquement conductrice à la puce semiconductrice (18, 19, 20).

8. Procédé de fabrication d'un composant optoélectronique (44) comprenant au moins une puce semiconductrice optoélectronique, dans lequel il est prévu un châssis de connexion (1) comprenant plusieurs sections de châssis de connexion reliées entre elles par l'intermédiaire de structures de renforcement, dans lequel au moins une puce semiconductrice (18, 19, 20) est appliquée sur une face supérieure d'une section de châssis de connexion (9), dans lequel le châssis de connexion (1) pourvu de la puce semiconductrice (18, 19, 20) est implanté dans un boîtier électriquement isolant, et dans lequel la section de châssis de connexion (9) pourvue de la puce semiconductrice (18, 19, 20) et d'au moins une structure de renforcement est séparée du reste du châssis de connexion (1) et le composant est obtenu, dans lequel la section de châssis de connexion (9) est reliée à une autre section de châssis de connexion par l'intermédiaire d'une structure de renforcement, et dans lequel, avant l'implantation dans le boîtier (28), un élément conducteur (21) est appliqué sur une face supérieure de l'autre section de châssis de connexion, et dans lequel, après l'implantation dans le boîtier (28), la section de châssis de connexion (9) pourvue de la puce semiconductrice (18, 19, 20), ladite au moins une structure de renforcement et l'autre section de châssis de connexion pourvue de l'élément conducteur (21) sont séparées du reste du châssis de connexion (1) et le composant est obtenu,
**caractérisé en ce que** la section de châssis de connexion (9) est reliée à l'autre section de châssis de connexion par l'intermédiaire de la structure de renforcement.

9. Procédé selon la revendication 8, dans lequel l'autre section de châssis de connexion et l'élément conducteur (21) sont divisés en au moins deux, notamment en quatre éléments conducteurs et quatre autres sections de châssis de connexion lors de la séparation d'un composant.

10. Procédé selon l'une des revendications 8 ou 9, dans lequel le composant est pourvu d'un autre boîtier (36), dans lequel l'autre boîtier (36) présente une structure conductrice (37), et dans lequel la structure conductrice (37) est reliée de manière électriquement conductrice à la puce semiconductrice (18, 19, 20).

11. Procédé selon l'une des revendications 8 ou 9, dans lequel ladite au moins une puce semiconductrice (18, 19, 20) présente une borne électrique au moins sur une face supérieure, dans lequel une ligne électrique (29, 30, 31) est appliquée sur une face supérieure du boîtier (28), et dans lequel la ligne électrique (29, 30, 31) est mise en contact électrique avec la borne électrique de la puce semiconductrice (18, 19, 20).
